# EUROPEAN PATENT APPLICATION

(11) **EP 4 586 325 A1**
(43) Date of publication of application: **16.07.2025**
(21) Application number: 23925081.4
(22) Date of filing: 19.12.2023
(51) Int. Cl.: H01L 31/18, H01L 31/068

(54) **BACK CONTACT SOLAR CELL AND MANUFACTURING METHOD THEREFOR**

(30) Priority: 02.03.2023 CN 202310217369
(71) Applicant: CHINT New Energy Technology Co., Ltd., Haining, Zhejiang 314400 (CN)
(72) Inventor: MA, Yuchao, Jiaxing, Zhejiang 314400 (CN); YE, Juyang, Jiaxing, Zhejiang 314400 (CN); CAI, Yongmei, Jiaxing, Zhejiang 314400 (CN); HE, Sheng, Jiaxing, Zhejiang 314400 (CN); HSU, Wei-chih, Jiaxing, Zhejiang 314400 (CN); HUANG, Haiyan, Jiaxing, Zhejiang 314400 (CN)
(74) Representative: PGA S.p.A., Milano, Succursale di Lugano
(86) International application number: PCT/CN2023/139762
(87) International publication number: WO 2024/179136

(57) **Abstract**

A back contact solar cell and a manufacturing method therefor. The manufacturing method comprises: a back surface of a silicon wafer having a first region and a second region, and forming a porous lattice in a tunneling layer located in the first region on the back surface of the silicon wafer; and forming a doped polycrystalline silicon layer on the surface of the tunneling layer facing away from the silicon wafer, where the doping concentration in the doped polycrystalline silicon layer is gradually reduced in the direction distant from the tunneling layer. According to the present application, a plurality of holes are formed in the tunneling layer, so that a carrier tunneling channel is formed in the tunneling layer; meanwhile, dopant atoms in the doped polycrystalline silicon layer can form atomic-level "pinholes" on the surface of the tunneling layer, enabling the tunneling contact resistance to be small. The region of the doped polycrystalline silicon layer that contacts the tunneling layer has the highest doping concentration, and forms a higher asymmetric offset barrier layer together with the tunneling layer, allowing majority carriers to pass through and not allowing minority carriers to pass through, i.e., enabling the collection of the majority of carriers to be more uniform and smooth, and improving the passivation effect, thereby improving the efficiency of the battery.

## Description

This application claims priority to Chinese Patent Application No. 202310217369.7, titled "BACK CONTACT SOLAR CELL AND MANUFACTURING METHOD THEREFOR", filed on March 02, 2023 with the China National Intellectual Property Administration, which is incorporated herein by reference in its entirety.

### FIELD

The present application relates to photovoltaic field and in particular to a back contact solar cell and a manufacturing method therefor.

### BACKGROUND

The positive and negative metal electrodes of the IBC (interdigitated back contact) battery are arranged in an interdigitated manner on the back face of the battery. There is no metal electrode blocking the front face, so the light incident on the front face of the battery can be used as much as possible, which improves the current density of the battery and thus improves the photoelectric conversion efficiency of the battery.

Taking the P-type IBC battery as an example, a SiOₓ tunneling layer and an N-type doped polysilicon layer are formed in the N region on the back face of the battery. The SiOₓ tunneling layer is generally deposited by LPCVD (low pressure chemical vapor deposition) or PECVD (plasma enhanced chemical vapor deposition). A thickness of the SiOₓ tunneling layer is uneven, which can easily cause many problems such as excessive tunneling resistance, poor passivation effect, and low carrier selectivity, resulting in low battery efficiency and even a certain proportion of inefficient and defective cells. In addition, the doping elements in the N-type doped polysilicon layer are evenly distributed in the doped polysilicon layer, and the tunneling contact resistance between the N-type doped polysilicon layer and the tunneling layer is relatively large, which hinders the collection of majority carriers, resulting in limited efficiency of the battery.

Therefore, how to solve the above technical problems should be the focus of those skilled in the art.

### SUMMARY

A purpose of the present application is to provide a back contact solar cell and a method for manufacturing the back contact solar cell, so as to improve the passivation effect of the cell and improve the efficiency of the cell.

To solve the above technical problems, the present application provides a method for manufacturing a back contact solar cell, comprising: a back face of a silicon wafer having a first region and a second region, forming a porous lattice in a tunneling layer located in the first region on the back face of the silicon wafer; forming a doped polysilicon layer on a surface of the tunneling layer away from the silicon wafer, where a doping concentration in the doped polysilicon layer gradually decreases in a direction away from the tunneling layer.

In one embodiment, the forming the porous lattice in the tunneling layer located in the first region on the back face of the silicon wafer comprises: etching the tunneling layer to form the porous lattice that does not completely penetrate the tunneling layer.

In one embodiment, the forming the porous lattice in the tunneling layer located in the first region on the back face of the silicon wafer comprises: etching the tunneling layer by laser or a corrosive solution containing an additive to form the porous lattice in the tunneling layer.

In one embodiment, the forming the doped polysilicon layer on the surface of the tunneling layer away from the silicon wafer comprises: depositing an intrinsic polysilicon layer on the surface of the tunneling layer away from the silicon wafer; doping the intrinsic polysilicon layer by a plurality of diffusion to form the doped polysilicon layer.

In one embodiment, a doping concentration of a region of the doped polysilicon layer adjacent to the tunneling layer is 1E20 atoms/cm³ to 6E20 atoms/cm³, a doping concentration of a region of the doped polysilicon layer farthest from the tunneling layer is 1E19 atoms/cm³ to 3E20 atoms/cm³.

In one embodiment, when the tunneling layer is etched by the laser, a pulse width of the laser ranges from 1ps to 50ns, and a wavelength of the laser ranges from 200nm to 800nm.

In one embodiment, when the tunneling layer is etched by the corrosive solution containing the additive, a concentration of the corrosive solution is in a range of 0.5% to 15%.

In one embodiment, before forming the porous lattice in the tunneling layer located in the first region on the back face of the silicon wafer, the method further comprises: depositing the tunneling layer on the back face of the silicon wafer, where the tunneling layer is any one or any combination of a silicon carbide layer, a silicon nitride layer, a silicon oxynitride layer, a silicon oxide layer, and an aluminum oxide layer.

In one embodiment, the depositing the tunneling layer in the first region on the back face of the silicon wafer comprises: depositing the tunneling layer on the back face of the silicon wafer using any one or any combination of PECVD, PEALD, LPCVD, PVD, ALD.

The present application further provides a back contact solar cell, comprising: a silicon wafer, where a back face of the silicon wafer has a first region and a second region with different doping types; a tunneling layer and a doped polysilicon layer are provided in the first region, where the tunneling layer has a porous lattice, and a doping concentration in the doped polysilicon layer gradually decreases in a direction away from the tunneling layer.

In one embodiment, the porous lattice does not completely penetrate the tunneling layer.

In one embodiment, the tunneling layer is any one or any combination of a silicon carbide layer, a silicon nitride layer, a silicon oxynitride layer, a silicon oxide layer, and an aluminum oxide layer.

The method for manufacturing the back contact solar cell according to the present application comprises: a back face of a silicon wafer having a first region and a second region, forming a porous lattice in a tunneling layer located in the first region on the back face of the silicon wafer; forming a doped polysilicon layer on a surface of the tunneling layer away from the silicon wafer, where a doping concentration in the doped polysilicon layer gradually decreases in a direction away from the tunneling layer.

It can be seen that in the process of manufacturing the cell according to the present application, a plurality of holes are formed in the tunneling layer, thereby forming a carrier tunneling channel on a surface of the tunneling layer, and the doped atoms in the doped polysilicon layer will form atomic-level "pinholes" on the surface of the tunneling layer, so that the tunneling contact resistance is small. Moreover, the doping concentration of the region of the doped polysilicon layer that contacts the tunneling layer is the highest. The region and the tunneling layer together form a higher asymmetric offset barrier layer, allowing majority carriers to pass through but minority carriers not to pass through, which makes the collection of majority carriers more uniform and smooth, improves the passivation effect, and thus improves the efficiency of the solar cell.

In addition, the present application further discloses a back contact solar cell having the above advantage.

### BRIEF DESCRIPTION OF THE DRAWINGS

In order to more clearly illustrate technical solutions of embodiments of the present application or the prior art, the drawings required for use in the embodiments or the prior art description will be briefly introduced below. Apparently, the drawings described below are only some embodiments of the present application. For those skilled in the art, other drawings may be obtained based on these drawings without creative work.
FIG. 1 is a flow chart of a method for manufacturing a back contact solar cell according to an embodiment of the present application.
FIG. 2 is a schematic structural diagram of a back contact solar cell according to an embodiment of the present application.
FIG. 3 is a schematic structural diagram of holes incompletely penetrating the tunneling layer according to an embodiment of the present application.

### DETAILED DESCRIPTION

In order to enable those skilled in the art to better understand the solutions of the present application, the present application is further described in detail below in conjunction with accompanying drawings and specific implementation methods. Apparently, the embodiments described are only part, not all of the embodiments of the present application. Based on the embodiments in the present application, all other embodiments obtained by those skilled in the art without creative work are within the scope of protection of the present application.

In the following description, many specific details are explained to facilitate a full understanding of the present application, but the present application may be implemented in other ways different from those described herein. Those skilled in the art can make similar generalizations without violating the connotation of the present application. Therefore, the present application is not limited by the specific embodiments disclosed below.

As described in the background technology, the uneven thickness of the tunneling layer in the current back contact solar cell may easily lead to many problems such as excessive tunneling resistance, poor passivation effect, low carrier selectivity, resulting in low battery efficiency. The tunneling contact resistance between the N-type doped polysilicon layer and the tunneling layer is relatively large, and the collection of majority carriers is hindered, resulting in limited battery efficiency.

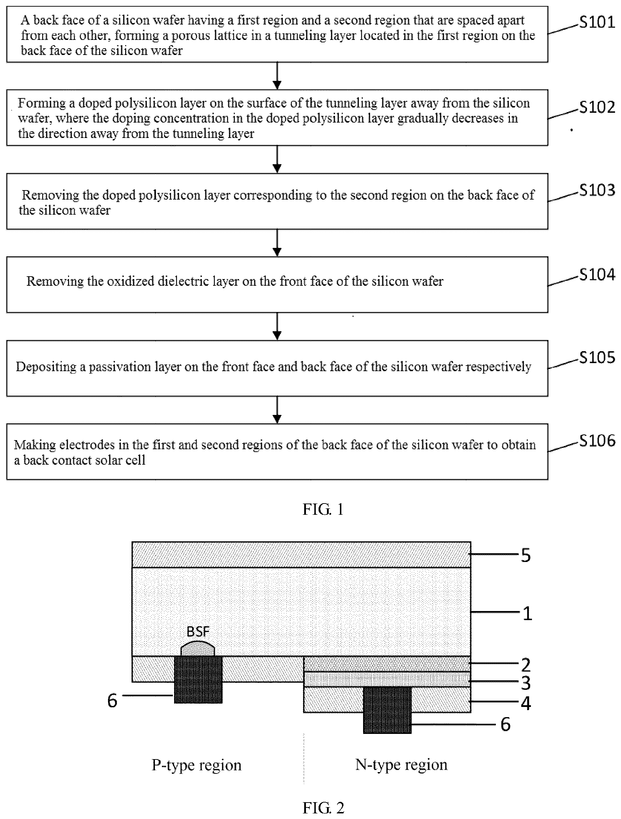

In view of the above, the present application provides a method for manufacturing a back contact solar cell, and referring to FIG. 1, the method comprises the following steps.

Step S101: a back face of a silicon wafer having a first region and a second region that are spaced apart from each other, forming a porous lattice in a tunneling layer located in the first region on the back face of the silicon wafer.

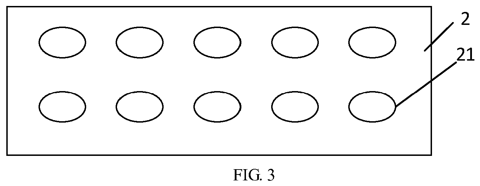

The porous lattice comprises multiple holes. There are two types of holes, one is holes that penetrate the tunneling layer, and the other is holes that not completely penetrate the tunneling layer. In one embodiment, the holes in the porous lattice do not completely penetrate the tunneling layer, so as to increase the carrier selectivity under the premise of satisfying passivation and contact. The structural schematic diagram of the holes 21 that do not completely penetrate the tunneling layer 2 is shown in FIG. 3.

It should be pointed out that the present application does not limit the method for forming the porous lattice.

In one embodiment, forming the porous lattice in the tunneling layer in the first region on the back face of the silicon wafer comprises: etching the tunneling layer using a laser to form the porous lattice in the tunneling layer.

When the tunneling layer is ablated by the laser, a pulse width of the laser may be 1ps to 50ns, and a wavelength of the laser may be 200nm to 800nm. Corresponding regular lattice micropores are formed in the tunneling layer, a size of the micropores is 0.1um to 50um, and a spacing of the micropores is 0.5µm to 4mm.

The holes that do not completely penetrate the tunneling layer may be formed on the surface of the tunneling layer by adjusting the wavelength, power and pulse width of the laser, so as to increase the carrier selectivity under the premise of satisfying passivation and contact.

In another embodiment, forming the porous lattice in the tunneling layer in the first region on the back face of the silicon wafer comprises: etching the tunneling layer using a corrosive solution containing an additive to form the porous lattice in the tunneling layer.

The role of the additive is to make the corrosive solution corrode selectively, and protect the local region on the surface of the tunneling layer from being corroded to form the porous lattice. The thickness of the tunneling layer after corrosion is controlled between 0.1nm to 10nm.

The corrosive solution may be either an acidic solution or an alkaline solution, both of which are within the scope of protection of the present application.

The material of the additive mainly contains organic/inorganic functional groups, which may effectively bind to the surface of the tunneling layer. However, due to the difference in binding force, there are certain differences in the protection of the surface, thus there are certain differences between the acid resistance and the alkali resistance. Therefore, when acid or alkali is used, micro-corrosion pits may be formed, namely, the porous lattice is formed.

In order to form holes that do not completely penetrate the tunneling layer, the tunneling layer is protected by protective additives, so that the reaction rate of the corrosive solution to the tunneling layer slows down, and holes that do not completely penetrate are etched to increase carrier selectivity under the premise of satisfying passivation and contact.

When the tunneling layer is etched by the corrosive solution containing the additive, the concentration of the acidic corrosive solution and the alkaline corrosive solution may be 0.5% to 15%, which is specifically set according to different additives, temperatures and reaction times.

In one embodiment, the silicon wafer is a P-type silicon wafer. After subsequent N-type doping (phosphorus doping), the first region corresponds to the N-type region of the cell, and the second region corresponds to the P-type region of the cell. When the silicon wafer is an N-type silicon wafer, the doped polysilicon layer is located in an entire region on the back face of the silicon wafer, and the doping type of the doped polysilicon layer corresponding to the N-type region is opposite to the doping type of the corresponding P-type region.

In one embodiment, before forming the porous lattice in the tunneling layer, the method further comprises: double-sided polishing of the silicon wafer; and forming a tunneling layer on the surface of the silicon wafer.

The purpose of polishing is to remove the cutting damage on the surface of the silicon wafer, smooth the surface, and reduce surface defects. The polishing can be conventional alkali polishing, using 5% to 20% potassium hydroxide solution, sodium hydroxide solution, TMAH (tetramethylammonium hydroxide) solution, or the like, and carrying out the chemical reaction at a temperature of 60°C to 90°C. Polishing additives may further be added to the solution to facilitate a flatter surface of the silicon wafer. The polishing additives may be purchased directly.

Materials and specific manufacturing methods of the tunneling layer are introduced in the following embodiments.

Step S102: forming a doped polysilicon layer on the surface of the tunneling layer away from the silicon wafer, where the doping concentration in the doped polysilicon layer gradually decreases in the direction away from the tunneling layer.

In order to enhance the selectivity of carriers and thus improve the battery efficiency, a doping concentration of the region of the doped polysilicon layer adjacent to the tunneling layer is 1E20 atoms/cm³ to 6E20 atoms/cm³. A doping concentration of the region of the doped polysilicon layer farthest from the tunneling layer is 1E19 atoms/cm³ to 3E20 atoms/cm³.

It should be noted that the method for forming the doped polysilicon layer is not limited in the present application.

In one embodiment, forming the doped polysilicon layer on the surface of the tunneling layer away from the silicon wafer comprises:
Step S102a1: depositing the intrinsic polysilicon layer on the surface of the tunneling layer away from the silicon wafer.
Step S102a2: doping the intrinsic polysilicon layer by a plurality of diffusion to form the doped polysilicon layer.

In order to gradually reduce the doping concentration of the doped polysilicon layer in the direction away from the tunneling layer, three aspects, such as a doping source concentration, a junction temperature and a diffusion time, may be controlled. For example, during the plurality of diffusion, the doping source concentration is gradually reduced, the junction temperature is gradually reduced, and the diffusion time is gradually shortened.

In this step, the diffusion is mainly divided into three steps. After the first step of diffusion, the diffusion concentration reaches 5E20cm⁻³. After the second step of diffusion, the diffusion concentration reaches 3E20cm⁻³. After the third step of diffusion, the diffusion concentration reaches 1E20cm⁻³.

The thickness of the intrinsic polysilicon layer may be in a range of 30nm to 300nm. The deposition method may be LPCVD, PEALD, PVD (physical vapor deposition), or the like.

In another embodiment, forming the doped polysilicon layer on the surface of the tunneling layer away from the silicon wafer comprises:
Step S102b1: depositing the intrinsic polysilicon layer on the surface of the tunneling layer away from the silicon wafer.
Step S102b2: doping the intrinsic polysilicon layer by a plurality of ion implantation to form the doped polysilicon layer.

In order to gradually reduce the doping concentration of the doped polysilicon layer in the direction away from the tunneling layer, the implantation dose, the time, and the like may be controlled.

The thickness of the intrinsic polysilicon layer may be in a range of 30nm to 300nm.

Step S103: removing the doped polysilicon layer corresponding to the second region on the back face of the silicon wafer.

It should be noted that before S 103 and after S102, the method further comprises: removing a part of an oxidized dielectric layer on the back face using laser. The P-type region may account for 10% to 40%, and the rest is the N-type region. The pulse width of the laser used is 1ps to 15ps, and the corresponding wavelength of the laser is generally 355nm. The oxidized dielectric layer is formed when the intrinsic polysilicon layer is doped. For example, the silicon wafer is a P-type silicon wafer, and when the intrinsic polysilicon layer is doped with phosphorus, the oxidized dielectric layer is phosphorus silicon glass.

An alkaline solution (such as 5% to 20% potassium hydroxide solution, sodium hydroxide solution, TMAH solution, or the like) may be used to remove the doped polysilicon layer corresponding to the P-type region at 60°C to 90°C, further to remove laser damage, smooth the surface, and reduce surface defects. Polishing additives may be further added to the alkaline solution to facilitate the surface being flatter.

Step S104: removing the oxidized dielectric layer on the front face of the silicon wafer.

The method for removing the oxidized dielectric layer on the front face of the silicon wafer may be removing the oxidized dielectric layer by performing single-sided etching using HF solution, a mixture of HF and HCl, an HNO₃ solution, or the like in an inline etch machine.

Step S105: depositing a passivation layer on the front face and back face of the silicon wafer respectively.

The passivation layer plays a role of chemical passivation. The passivation layer on the front face may be a stacking layer of an aluminum oxide layer, a silicon nitride layer, and a silicon oxide layer. The corresponding thickness may be 2nm to 20nm, 50nm to 80nm, 5nm to 20nm, and the manufacturing method includes but is not limited to PECVD, ALD (atomic layer deposition), PEALD (plasma enhanced atomic layer deposition). The passivation layer on the back face may be a stacking layer of an aluminum oxide layer and a silicon nitride layer, and the corresponding thickness may be 2nm to 20nm, 60 nm to 200nm, and the manufacturing method includes but is not limited to PECVD, ALD, and PEALD.

Step S106: making electrodes in the first and second regions of the back face of the silicon wafer to obtain a back contact solar cell.

The first region corresponds to the N-type region, and the second region corresponds to the P-type region. A local opening is made in the N-type region using a laser or an acid etching material. The opening shape is any one of dot, dot-spaced, line, line-spaced, and dot and line-spaced. A diameter or width of the opening is 10µm to 50µm. It should be noted that the opening region only removes the passivation layer without damaging the underlying doped polysilicon layer. A low-corrosive silver paste or silver-aluminum paste is printed above the opening region of the N-type region, with a width of 50µm to 100µm, which serves as an electrical contact to the doped polysilicon layer. A corrosive silver paste is printed above the doped polysilicon layer. A glass frit in the corrosive silver paste may open the passivation layer, so that the silver contacts the doped polysilicon layer. The electrode paste is printed directly on the passivation layer in the P-type region, and co-sintered at 600°C to 800°C to form an electrode.

In the process of manufacturing the cell according to the present application, a plurality of holes are formed in the tunneling layer, thereby forming a carrier tunneling channel on a surface of the tunneling layer, and the doped atoms in the doped polysilicon layer will form atomic-level "pinholes" on the surface of the tunneling layer, so that the tunneling contact resistance is small. Moreover, the doping concentration of the region of the doped polysilicon layer that contacts the tunneling layer is the highest. The region and the tunneling layer together form a higher asymmetric offset barrier layer, allowing majority carriers to pass through but minority carriers not to pass through, which makes the collection of majority carriers more uniform and smooth, improves the passivation effect, and thus improves the efficiency of the solar cell.

Based on the above embodiments, in one embodiment, after the doped polysilicon layer is formed on the surface of the tunneling layer away from the silicon wafer, the method further comprises: texturing the silicon wafer.

Specifically, the texturing is performed after removing the oxidized dielectric layer on the front face of the silicon wafer and before preparing the passivation layer.

During texturing, an alkaline solution, such as 5-20% potassium hydroxide solution, sodium hydroxide solution, TMAH solution, or the like, may be used to perform the texturing process under the action of texturing additives. A pyramid structure is formed in the region not covered and protected by the oxidized dielectric layer, that is, the entire front face is a pyramid textured surface, which plays a light trapping role. The polysilicon (poly-Si) on the front face of the silicon wafer may further be removed by texturing.

In order to avoid forming a textured structure on the back face of the silicon wafer, after removing the doped polysilicon layer corresponding to the P-type region on the back face of the silicon wafer, the back face of the silicon wafer may further be oxidized to form a protective layer. The oxidation method may be a thermal oxidation method or an ultraviolet ozone method. The oxide layer is removed by an acidic solution after texturing.

On the basis of any of the above embodiments, in one embodiment, before forming the porous lattice in the tunneling layer located in the first region on the back face of the silicon wafer, the method further comprises:
depositing the tunneling layer on the back face of the silicon wafer, where the tunneling layer is any one or any combination of silicon carbide layer, silicon nitride layer, silicon oxynitride layer, silicon oxide layer, and aluminum oxide layer.

The thickness of the tunneling layer may be in a range of 0.1nm to 10nm.

In the conventional technology, the material of the tunneling layer is silicon oxide. In the present application, in addition to silicon oxide, the material of the tunneling layer may be silicon carbide, silicon nitride, silicon oxynitride, and aluminum oxide, which have the same tunneling effect.

In one embodiment, depositing the tunneling layer on the back face of the silicon wafer comprises:
depositing the tunneling layer on the back face of the silicon wafer by using any one or any combination of PECVD, PEALD, LPCVD, PVD, and ALD.

When the tunneling layer is deposited, an entire surface may be deposited, and then a portion corresponding to the second region may be removed.

The manufacturing method according to the present application is introduced below, taking P-type silicon wafer as an example.

### Step 1, double-sided polishing of P-type silicon wafer

Conventional alkaline polishing was performed by conducting a chemical reaction at a temperature of 60°C to 90°C using 5% to 20% of potassium hydroxide, sodium hydroxide, TMAH solution or the like containing polishing additives, to achieve double-sided polishing.

### Step 2, depositing the tunneling layer on the back face

The tunneling layer was deposited by using any one of LPCVD, PECVD, PEALD, PVD, and ALD. The tunneling layer may be one or more of oxide, nitride and oxynitride of Si and aluminum oxide, with a thickness of 0.1nm to 10nm.

### Step 3, laser micro-ablating or wet micro-etching tunneling layer

When a dry process was performed, the surface of tunneling layer was micro-ablated using a laser with a pulse width of 1ps to 50ns and a wavelength of 200nm to 800nm. The corresponding regular lattice micropores were formed on the surface of the tunneling layer, the size of the micropores was 0.1µm to 50µm, and the spacing of the micropores was 0.5µm to 4mm.

When the wet process was performed, the tunneling layer was micro-etched using an acidic solution or an alkaline solution containing additives to form a porous structure on the surface of the tunneling layer. The tunneling layer after etching was controlled at a thickness of 0.1nm to 10nm.

### Step 4, depositing the intrinsic amorphous silicon layer

The intrinsic amorphous silicon layer was deposited on the surface of the tunneling layer by using any one method of LPCVD, PEALD, and PVD with a thickness of 30nm to 300nm.

### Step 5, n-type doping

P doping was performed by multi-step P (phosphorus) diffusion. The P doping concentration close to the tunneling layer was 1E20 atoms/cm³ to 6E20 atoms/cm³, and the P doping concentration away from the tunneling layer was 1E19 atoms/cm³ to 3E20 atoms/cm³.

### Step 6, laser patterning

A part of the PSG layer on the back face was removed by using picosecond ultraviolet laser. The P-type region accounted for 10%-40%, and the rest was the N-type region. The pulse width of the laser used was 1ps-15ps, and the corresponding wavelength of the laser was 355nm.

### Step 7, alkali washing + oxidation

Conventional alkali polishing was performed by conducting a chemical reaction at a temperature of 60°C to 90°C using 5-20% of potassium hydroxide, sodium hydroxide, TMAH solution, or the like. Polishing additives was added to facilitate a flatter surface, and the purpose was to remove the laser damage on the surface and the N-type doped polysilicon layer in the P region, smooth the surface, and reduce surface defects.

A protective layer was formed in a polished region on the back face by the thermal oxidation method or the ultraviolet ozone method to avoid forming a textured surface during texturing.

### Step 8: PSG removal + texturing

The PSG layer on the front face of the silicon wafer was removed by performing single-sided etching using an acid solution in an inline etch machine.

The texturing was performed using 5-20% of potassium hydroxide, sodium hydroxide, and TMAH solution to form a pyramid structure in the region not covered and protected by the PSG layer. That is, the entire front face was a pyramid textured surface, which played a role in light trapping, and the poly-Si on the front face of the silicon wafer may be removed by texturing.

### Step 9, passivation of the front face and the back face by stacking layer

Deposition of hydrogen-containing dielectric layers on the front face and back face played a role in chemically passivating the back surface, where the back face was a stacking film of aluminum oxide + silicon nitride, and the front face is a stacking film of aluminum oxide + silicon nitride + silicon oxide.

### Step 10, metallization of the back face

The N-type region was partially opened by laser or acid etching materials without damaging the underlying N-type polysilicon layer. Low-corrosive silver paste or silver-aluminum paste was printed above the opening region of the N-type region. Corrosive silver paste was printed above the N-type polysilicon. The glass frit in the corrosive silver paste may open the passivation layer, so that the silver contacts the N-type polysilicon. The electrode paste was directly printed in the P-type region, and co-sintered at 600°C to 800°C to form an electrode.

The present application further provides a back contact solar cell, as shown in FIG. 2, comprising: a silicon wafer 1, wherein the back face of the silicon wafer 1 has a first region and a second region with different doping types, which are spaced apart from each other; a tunneling layer 2 and a doped polysilicon layer 3 are provided in the first region, where the tunneling layer 2 has a porous lattice, and the doping concentration in the doped polysilicon layer 3 gradually decreases in the direction away from the tunneling layer 2.

The back contact solar cell further comprises a front passivation layer 5 provided on the front face of the silicon wafer 1, a back passivation layer 4 provided on the back face of the silicon wafer 1 and an electrode 6. The front passivation layer 5 may be a stacking layer of an aluminum oxide layer, a silicon nitride layer, and a silicon oxide layer. The back passivation layer 4 may be a stacking layer of an aluminum oxide layer and a silicon nitride layer.

The silicon wafer 1 may be a P-type silicon wafer. The doping type of the doped polysilicon layer 3 is N-type doping, and the doping element may be phosphorus. Correspondingly, the first region is an N-type region, and the second region is a P-type region.

The tunneling layer 2 includes but is not limited to any one or any combination of silicon carbide layer, silicon nitride layer, silicon oxynitride layer, silicon oxide layer, and aluminum oxide layer.

The porous lattice comprises multiple holes. There are two types of holes, one type is holes that penetrate the tunneling layer, and the other type is holes that not completely penetrate the tunneling layer. Preferably, the holes in the porous lattice do not completely penetrate the tunneling layer, so as to increase the carrier selectivity under the premise of satisfying passivation and contact.

The various embodiments in this specification are described in a progressive manner, and each embodiment focuses on differences from other embodiments. The same or similar parts between the embodiments can be referred to each other.

The back contact solar cell and the manufacturing method therefor provided by the present application are described in detail above. This application uses specific embodiments to explain the principles and implementation methods of the present application. The description of the above embodiments is only used to help understand the method and its core idea of the present application. It should be pointed out that for those skilled in the art, without departing from the principles of the present application, several improvements and modifications can be made to the present application, and these improvements and modifications also fall within the scope of protection of the claims of the present application.

## Claims

1. A method for manufacturing a back contact solar cell, comprising:
a back face of a silicon wafer having a first region and a second region, forming a porous lattice in a tunneling layer located in the first region on the back face of the silicon wafer;
forming a doped polysilicon layer on a surface of the tunneling layer away from the silicon wafer, wherein a doping concentration in the doped polysilicon layer gradually decreases in a direction away from the tunneling layer.

2. The method for manufacturing the back contact solar cell according to claim 1, wherein the forming the porous lattice in the tunneling layer located in the first region on the back face of the silicon wafer comprises:
etching the tunneling layer to form the porous lattice that does not completely penetrate the tunneling layer.

3. The method for manufacturing the back contact solar cell according to claim 1 or 2, wherein the forming the porous lattice in the tunneling layer located in the first region on the back face of the silicon wafer comprises:
etching the tunneling layer by laser or a corrosive solution containing an additive to form the porous lattice in the tunneling layer.

4. The method for manufacturing the back contact solar cell according to claim 1, wherein the forming the doped polysilicon layer on the surface of the tunneling layer away from the silicon wafer comprises:
depositing an intrinsic polysilicon layer on the surface of the tunneling layer away from the silicon wafer;
doping the intrinsic polysilicon layer by a plurality of diffusion to form the doped polysilicon layer.

5. The method for manufacturing the back contact solar cell according to claim 1, wherein a doping concentration of a region of the doped polysilicon layer adjacent to the tunneling layer is 1E20 atoms/cm³ to 6E20 atoms/cm³, a doping concentration of a region of the doped polysilicon layer farthest from the tunneling layer is 1E19 atoms/cm³ to 3E20 atoms/cm³.

6. The method for manufacturing the back contact solar cell according to claim 2, wherein when the tunneling layer is etched by the laser, a pulse width of the laser ranges from 1ps to 50ns, and a wavelength of the laser ranges from 200nm to 800nm.

7. The method for manufacturing the back contact solar cell according to claim 3, wherein when the tunneling layer is etched by the corrosive solution containing the additive, a concentration of the corrosive solution is in a range of 0.5% to 15%.

8. The method for manufacturing the back contact solar cell according to claim 1, wherein before forming the porous lattice in the tunneling layer located in the first region on the back face of the silicon wafer, the method further comprises:
depositing the tunneling layer on the back face of the silicon wafer, wherein the tunneling layer is any one or any combination of a silicon carbide layer, a silicon nitride layer, a silicon oxynitride layer, a silicon oxide layer, and an aluminum oxide layer.

9. The method for manufacturing the back contact solar cell according to claim 8, wherein the depositing the tunneling layer in the first region on the back face of the silicon wafer comprises:
depositing the tunneling layer on the back face of the silicon wafer using any one or any combination of PECVD, PEALD, LPCVD, PVD, and ALD.

10. A back contact solar cell, comprising:
a silicon wafer, wherein a back face of the silicon wafer has a first region and a second region with different doping types; a tunneling layer and a doped polysilicon layer are provided in the first region, wherein the tunneling layer has a porous lattice, and a doping concentration in the doped polysilicon layer gradually decreases in a direction away from the tunneling layer.

11. The back contact solar cell according to claim 10, wherein the porous lattice does not completely penetrate the tunneling layer.

12. The back contact solar cell according to claim 10 or 11, wherein the tunneling layer is any one or any combination of a silicon carbide layer, a silicon nitride layer, a silicon oxynitride layer, a silicon oxide layer, and an aluminum oxide layer.
